# EUROPEAN PATENT APPLICATION

(11) **EP 2 827 565 A1**
(43) Date of publication of application: **21.01.2015**
(21) Application number: 12871276.7
(22) Date of filing: 12.12.2012
(51) Int. Cl.: H04M 1/02, H05K 5/02

(54) **PORTABLE TERMINAL DEVICE**

(30) Priority: 12.03.2012 JP 2012054245
(71) Applicant: NEC Corporation, Tokyo 108-8001 (JP); NTT DOCOMO, INC., Chiyoda-ku Tokyo 100-6150 (JP)
(72) Inventor: SHIRAISHI, Mitsutaka, Kanagawa 211-8666 (JP)
(74) Representative: Vossius & Partner
(86) International application number: PCT/JP2012/007936
(87) International publication number: WO 2013/136398

(57) **Abstract**

A portable terminal device (1) according to the present invention includes a display section (4) and a housing (10) to which the display section (4) is fixed. The housing (10) includes a housing main body (11), a first component (12), and a second component (13). The housing main body (11) contains a conductive material and is formed with a cut-out part in a place corresponding to a place where antennas (9_1, 9_2) are disposed at an end of the housing (10). The first component (12) is arranged at the cut-out part of the housing main body (11) and contains material that transmits radio waves. The second component (13) is formed at the end of the housing (10) and has a higher rigidity than that of the first component (12).

## Description

### Technical Field

The present invention relates to a portable terminal device, and in particular, a portable terminal device using a thin planar housing.

### Background Art

In recent years, portable terminal devices such as mobile phones and smart phones have become widespread. In general, portable terminal devices are often carried around for use by users. When a user, for example, accidentally drops a portable terminal device, a strong impact is exerted on the portable terminal device.

Patent Literature 1 discloses a technique for a liquid crystal device capable of preventing deterioration of the orientation property and the image quality of the liquid crystal panel even when a strong impact is exerted on the liquid crystal device. In the liquid crystal device disclosed in Patent Literature 1, a vibration impact resistance unit in which two impact absorbing spaces are disposed on both sides of a liquid crystal panel for preventing an impact exerted on a liquid crystal main body from being transmitted to the liquid crystal panel is fixed to a fixing component. Then, by fixing this fixing component to which the vibration impact resistance unit is fixed to a first exterior component that forms the outer surface of the liquid crystal device main body, the vibration impact resistance unit is indirectly fixed to the first exterior component in order to prevent a strong impact exerted on the liquid crystal device main body from being transmitted to the liquid crystal panel.

Patent Literature 2 discloses a technique for a lightweight and high-rigidity housing for a portable terminal device that enables a reduction of the number of components and assembly man-hours when an upper part and a bottom part of the housing are fastened by screws.

### Citation List

### Patent Literature

Patent literature 1: Japanese Unexamined Patent Application Publication No. H10-90656
Patent literature 2: Japanese Unexamined Patent Application Publication No. 2007-281069

### Summary of Invention

### Technical Problem

In recent years, portable terminal devices such as mobile phones and smart phones have been becoming thinner and thinner. However, as portable terminal devices become thinner, the strength of the portable terminal devices is lowered and hence the impact resistance thereof is lowered. Regarding this problem, it is possible to provide a portable terminal device capable of achieving a reduction in the thickness and an improvement in the impact resistance of the portable terminal device by configuring a housing of the portable terminal device with rigid material (e.g., metal material or carbon composite material).

However, when the housing of the portable terminal device is formed by using metal material or carbon composite material, there is a problem that a sensitivity of an antenna disposed in the portable terminal device is reduced, because these materials are conductive materials. Regarding this problem, it is possible to suppress the reduction of the sensitivity of the antenna by using material that transmits radio waves in a place corresponding to a place where the antenna is disposed in the housing. However, when the material that transmits radio waves is used in a part of the housing, there is a problem that the rigidity and the impact resistance of the portable terminal device are reduced because the material that transmits radio waves would be resin material or the like that has low rigidity.

In view of the above-described problem, an object of the present invention is to provide a portable terminal device capable of improving the impact resistance of the portable terminal device without reducing the sensitivity of the antenna.

### Solution to Problem

A portable terminal device according to an aspect of the present invention includes: a display section and a housing to which the display section is fixed, wherein the housing includes: a housing main body that contains a conductive material and is formed with a cut-out part in a place corresponding to a place where an antenna is disposed at an end of the housing; a first component that is arranged at the cut-out part and contains material that transmits radio waves; and a second component that is formed so as to surround the first component at the end of the housing and has a higher rigidity than that of the first component.

### Advantageous Effects of Invention

According to the present invention, it is possible to provide a portable terminal device capable of improving the impact resistance of the portable terminal device without reducing the sensitivity of the antenna.

### Brief Description of Drawings

Fig.lA is a top view showing a portable terminal device according to an exemplary embodiment;
Fig. 1B is a cross section of the portable terminal device shown in Fig. 1A taken along a line IB-IB in Fig. 1A;
Fig.1C is a top view of a housing of the portable terminal device according to the exemplary embodiment;
Fig. 2 is a perspective view of the portable terminal device according to the exemplary embodiment as viewed from a housing side;
Fig. 3 is a bottom view of the portable terminal device according to the exemplary embodiment;
Fig. 4 is a cross section of the portable terminal device shown in Fig. 3 taken along a line IV-IV in Fig. 3;
Fig. 5 is a bottom view showing another example of the portable terminal device according to the exemplary embodiment;
Fig. 6 is a bottom view showing another example of the portable terminal device according to the exemplary embodiment;
Fig. 7 is a bottom view showing another example of the portable terminal device according to the exemplary embodiment;
Fig. 8 is a bottom view showing another example of the portable terminal device according to the exemplary embodiment;
Fig. 9 is a bottom view showing another example of the portable terminal device according to the exemplary embodiment; and
Fig. 10 is a bottom view showing another example of the portable terminal device according to the exemplary embodiment.

### Description of Embodiments

Exemplary embodiments according to the present invention are explained hereinafter with reference to the drawings.

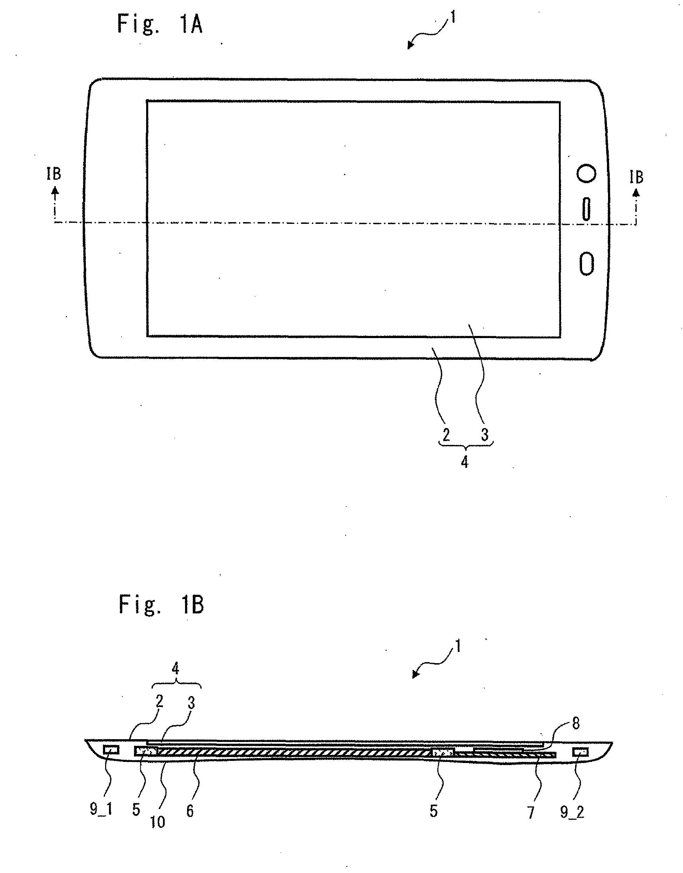

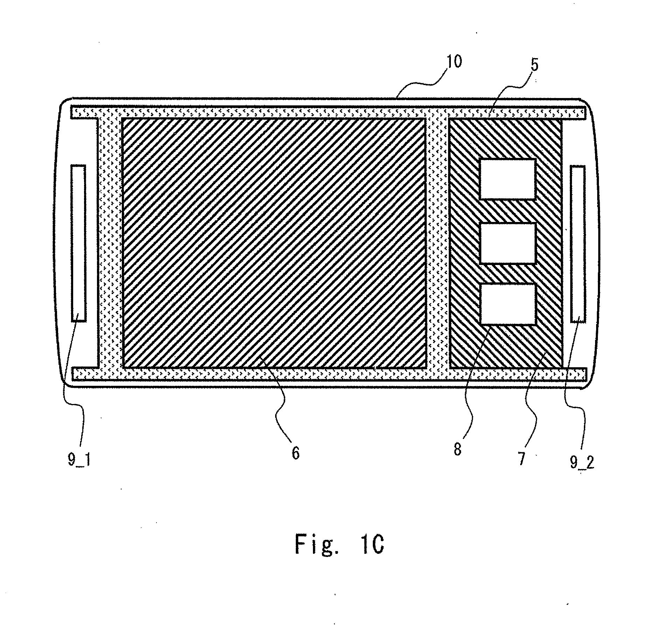

Figs.1A to 1C show a portable terminal device according to an exemplary embodiment. Fig.1A is a top view showing the portable terminal device according to this exemplary embodiment. Fig. 1B is a cross section of the portable terminal device shown in Fig. 1A taken along a line IB-IB in Fig. 1A. Fig.1C is a top view of a housing of the portable terminal device according to this exemplary embodiment (i.e., a figure in which a display section is omitted).

In the potable terminal device 1 according to this exemplary embodiment, a frame component 5, a battery 6, a substrate 7, and antennas 9_1 and 9_2 are housed in a space that is formed by joining a display section 4 with a housing 10. The portable terminal device 1 according to this exemplary embodiment may be, for example, a smart phone, a tablet-type portable terminal device, a mobile phone, a game machine, an electronic book reader, or the like.

As shown in Figs. 1A and 1B, the display section 4 includes a panel 2 and a display panel 3. The panel 2 is a component for protecting the display panel 3 from an external environment. The panel 2 may be a touch panel. The display panel 3 is attached to the panel 2 by using an adhesive, a double-sided adhesive tape, or the like. The display panel 3 is, for example, a liquid crystal panel, an organic EL (Electro Luminescence) panel, or the like.

Further, as shown in Figs. 1B and 1C, the battery 6 and the substrate 7 are fixed to the frame component 5 by using screws or the like. For example, the battery 6 and the substrate 7 are fixed to the frame component 5 from the housing 10 side. The frame component 5, to which the battery 6 and the substrate 7 are fixed, is fixed to the housing 10 by using screws or the like.

The battery 6 is, for example, a lithium-ion secondary battery. Further, a circuit component 8 is provided on the substrate 7. For example, the circuit component 8 is disposed on the surface of the substrate 7 to which the display section 4 is faced. Examples of the circuit component 8 include an integrated circuit device such as a processor, a memory, and a communication module, and an image sensing device for a camera.

Since the frame component 5 is a component for holding the battery 6 and the substrate 7, the frame component 5 needs to have a certain strength. Therefore, the frame component 5 is preferably formed by using metal material. Examples of the material for the frame component 5 include magnesium alloys, aluminum, aluminum alloys, and stainless steel. Note that to reduce the weight of the portable terminal device 1, the frame component 5 is preferably formed by using a magnesium alloy. Alternatively, the frame component 5 may be formed by using resin material, provided that the certain strength is ensured.

Further, the antennas 9_1 and 9_2 are disposed in the ends of the housing 10. Although the two antennas 9_1 and 9_2 are disposed in both ends in the longitudinal direction of the housing 10 in the example shown in Figs. 1 Band 1C, only one antenna may be provided in other examples. In the case where only one antenna is provided, the antenna is disposed in one of the ends in the longitudinal direction of the housing 10.

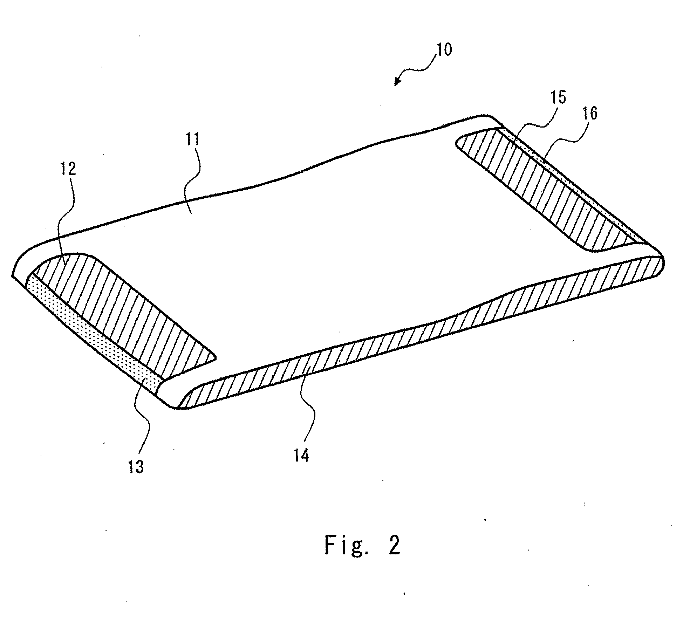

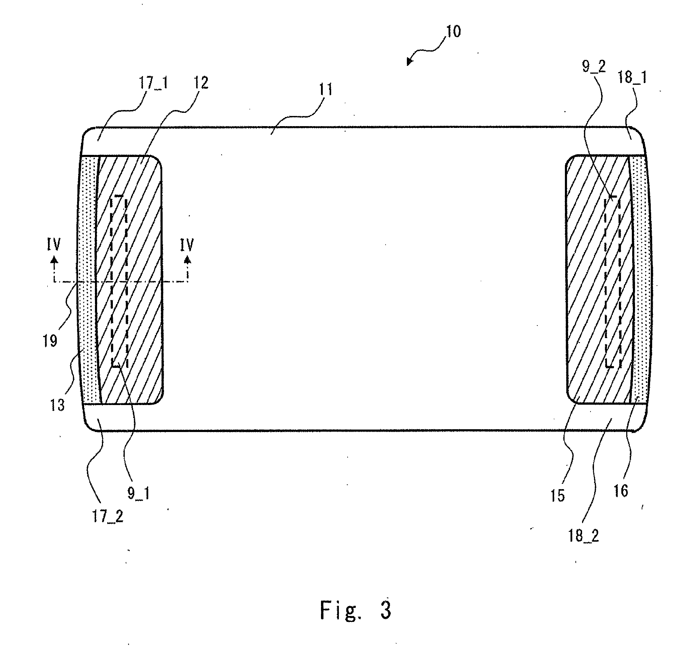

Fig. 2 is a perspective view of the portable terminal device according to this exemplary embodiment as viewed from a housing 10 side. Fig. 3 is a bottom view (i.e., the figure viewed from the housing 10 side) of the portable terminal device according to this exemplary embodiment. As shown in Figs. 2 and 3, the housing 10 includes a housing main body 11, first components 12 and 15, and second components 13 and 16. Note that, sides of the housing 10, as shown in Fig. 2, can be configured by using resin material 14. Further, the rear surface of the housing 10 shown in Fig. 2 is formed so as to have a curved line(s) so that the portable terminal device fits a user's hand. Alternatively, the rear surface of the housing 10 may be formed as a flat surface.

It is preferable that the housing main body 11 be formed by using the rigid material to maintain the strength of the portable terminal device 1. For example, the housing main body 11 can be formed of carbon composite material (CFRP: Carbon Fibers Reinforced Plastics). The carbon composite material is composite material in which the amount of carbon contained therein is 50% (v/v) or greater, and contains an inorganic binder such as silica and alumina, fibers, and so on. The carbon composite material has both a high strength and a light weight. Alternatively, the housing main body 11 may be formed by using metal material such as aluminum, aluminum alloys, magnesium alloys, or the like.

Since the carbon composite material that configures the housing main body 11 is a conductive material, the radio waves would be blocked. That is, the housing main body 11 would have a shielding property. For this reason, in the portable terminal device according to this exemplary embodiment, cut-out parts are formed in a place corresponding to a place where the antennas 9_1 and 9_2 are disposed at the housing main body 11. Further, first components 12 and 15 that are formed by using the materials that transmit radio waves are arranged at the cut-out parts. This configuration makes it possible to prevent the radio waves from being blocked and to suppress the reduction of the sensitivity of the antennas. For example, insulating material such as resin material or the like is used for the material that configures the first components 12 and 15.

In this case, the first components 12 and 15 formed by using resin material are weaker than the housing main body 11 formed by the carbon composite material. When the first components 12 and 15 are arranged in the ends of the housing 10, the strength of the housing 10 becomes weakened. Thus, when an impact is exerted on the ends of the housing 10, the effect of impact reaches to the antennas 9_1 and 9_2, and thus the antennas 9_1 and 9_2 may be broken. For this reason, in the portable terminal device according to this exemplary embodiment, second components 13 and 16 that have higher rigidity than those of the first components 12 and 15 are formed at the ends of the housing to protect the first components 12 and 15 and the antennas 9_1 and 9_2 from the external impact. That is, the second components 13 and 16 are formed so as to surround the first components 12 and 15 at the ends of the housing 10.

In other words, as shown in Fig. 3, the second component 13 is formed from the protruding part 17_1 to the protruding part 17_2 that are formed at both sides of the cut-out part (i.e., corresponding to a place where the first component 12 is arranged) of the housing main body 11. Similarly, the second component 16 is formed from the protruding part 18_1 to the protruding part 18_2 that are formed at both sides of the cut-out part (i.e., corresponding to a place where the first component 15 is arranged) of the housing main body 11. By joining the second component 13 and 16 formed by rigid material to the protruding parts 17_1, 17_2, 18_1, 18_2 formed by rigid material such as carbon composite material, it is possible to improve the rigidity of the housing 10 at longitudinal ends of the housing 10 and protect the first components 12 and 15 and antennas 9_1 and 9_2 from the impact.

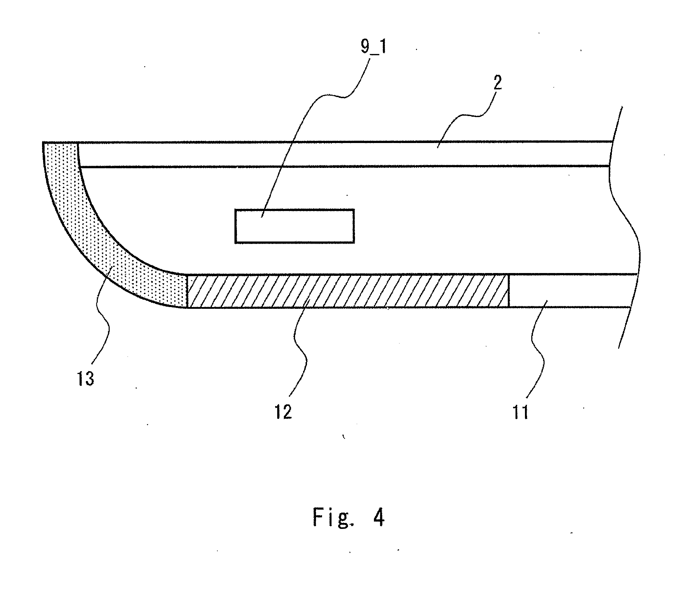

Fig. 4 is a cross section of the portable terminal device shown in Fig. 3 taken along a line IV-IV in Fig. 3. As shown in Fig. 4, in the potable terminal device according to this exemplary embodiment, the first component 12 formed by the material that transmits radio waves is arranged in a place corresponding to a place where the antenna 9_1 is disposed. Therefore, it is possible to prevent the radio waves that would be received by the antenna 9_1 from being blocked. Further, the second component 13 that has a higher rigidity than that of the first component 12 is disposed at a longitudinal end of the housing 10. Therefore, it is possible to protect the antenna 9_1 and the first component 12 from the impact exerted on the longitudinal end of the housing 10.

Here, resin material that has higher rigidity than the first components 12 and 15 can be used as the material of the second components 13 and 16. In the case where the second components 13 and 16 are arranged in an area where the second components 13 and 16 have no influence on the receiving sensitivity of the antenna 9_1 and 9_2, the second components 13 and 16 can be formed by using metal material such as aluminum, aluminum alloys, magnesium alloys, or the like, and carbon composite material. Further, the rigidity of the second components 13 and 16 can be increased compared with the rigidity of the first components 12 and 15 by thickening the thickness of the second components 13 and 16 compared with the thickness of the first components 12 and 15. In this case, the same resin material as that used for the first components 12 and 15 can be used as the material for the second components 13 and 16.

The housing 10 including the housing main body 11 formed by the carbon composite material, the first components 12 and 15 formed by the resin material, and the second components 13 and 16 formed by the high-rigidity material can be formed by, for example, placing the housing main body 11 formed by the carbon composite material in a predetermined part of a die for the housing 10 and then performing two-color injection molding for the first components 12 and 15 formed by the resin material and the second components 13 and 16 formed by the high-rigidity material.

Note that, in the example shown in Figs. 2 and 3, the case where the two antennas 9_1 and 9_2 are disposed in both ends in the longitudinal direction of the housing 10, and the cut-out parts of the housing main body 11, the first components 12 and 15 and the second components 13 and 16 are disposed in the area corresponding to the two antennas 9_1 and 9_2, has been shown. However, only one antenna may be disposed in one of the longitudinal ends of the housing 10. In this case, the cut-out part, the first component, and the second component can be disposed in an area corresponding to the only one antenna.

Further, when the housing main body 11 is formed by using the carbon composite material, the housing main body 11 can be configured as follows. The carbon composite material contains carbon fibers and has such properties that the strength is large along the direction of the carbon fibers. Therefore, by arranging carbon fibers in the longitudinal direction of the housing 11, the strength in the longitudinal direction of the housing 11 can be improved, thus improving the resistance to impacts that would be exerted when the portable terminal device is dropped.

In this case, it is possible to further improve the strength in the longitudinal direction of the housing main body 11 by arranging the direction of the carbon fibers in the longitudinal direction of the housing main body 11, the carbon fibers being disposed at the outside (i.e., front surface and rear surface of the housing main body 11), not at the middle part in the thickness direction of the housing main body 11. That is, when the housing main body 11 is formed by stacking a plurality of carbon fiber layers, it is possible to improve the strength in the longitudinal direction of the housing main body 11 by arranging the direction of the carbon fibers of the carbon fiber layers disposed at the front surface and the rear surface of the housing main body 11 in the longitudinal direction of the housing main body 11.

For example, in a case where the housing main body 11 is formed by stacking four layers of the carbon fiber layers, the direction of the carbon fibers of the carbon fiber layers disposed at the front surface and the rear surface of the housing main body 11 may be arranged in the longitudinal direction of the housing main body 11, and the direction of the carbon fibers of two carbon fiber layers disposed at the middle part of the housing main body 11 may be arranged in the direction intersecting the longitudinal direction of the housing main body 11. This configuration makes it possible to further improve the strength in the longitudinal direction of the housing main body 11, while maintaining the strength in the direction intersecting the longitudinal direction of the housing main body 11.

Further, as shown in Fig. 3, the housing 10 may have a curvature structure at the longitudinal end thereof. That is, the second component 13 that is formed of the high-rigidity material and disposed at the longitudinal end of the housing 10 may be formed so as to have the curvature structure. In this case, it is preferable that the housing 10 be formed in such a way that the second component 13 includes an apex 19 because the apex 19 of the curvature structure is likely to bump against something when the portable terminal device is dropped. In other words, the apex 19 of the curvature structure is the most protruding part in the curvature structure in the longitudinal direction of the housing 10.

As mentioned above, in the portable terminal device according to this exemplary embodiment, the first components 12 and 15 that are formed by using the materials that transmit radio waves are arranged in a place corresponding to a place where the antennas 9_1 and 9_2 are disposed. This configuration makes it possible to prevent the radio waves received by the antennas 9_1 and 9_2 from being blocked. Further, the second components 13 and 16 that have higher rigidity than that of the first components 12 and 15 are formed at the ends of the housing 10. This configuration makes it possible to protect the antennas 9_1 and 9_2 and the first components 12 and 15 from the impact exerted on the ends of the housing 10.

Thus, according to the present invention, it is possible to provide a portable terminal device capable of improving the impact resistance of the portable terminal device without reducing the sensitivity of the antenna.

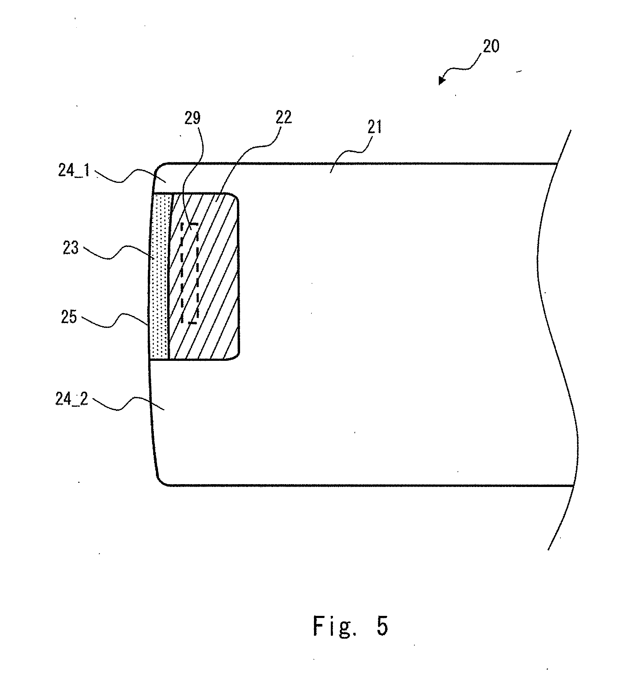

Next, other examples of the portable terminal device according to the exemplary embodiment are explained hereinafter. For example, as shown in Fig. 5, in the case where the length of the antenna 29 is short, the cut-out part formed at the housing main body 21 of the housing 20, the first component 22 arranged in the cut-out part, and the second component 23 formed from the protruding part 24_1 to the protruding part 24_2 can be configured so that their respective lengths are shortened so as to correspond to the length of the antenna 29. Further, in the case where the housing 20 has the curvature structure at the longitudinal end thereof, the second component 23 can be configured so as to include the apex 25 of the curvature structure.

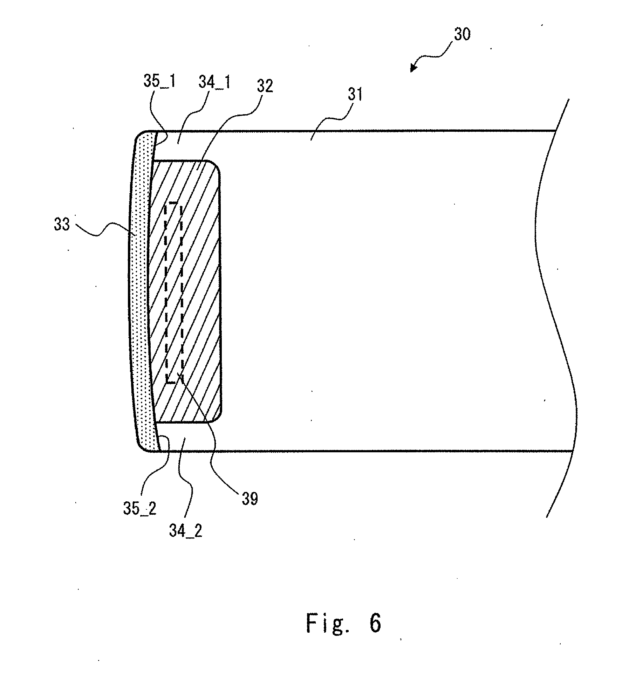

As shown in Fig. 6, in the portable terminal device according to this exemplary embodiment, when the second component 33 is formed from the protruding parts 34_1 to the protruding parts 34_2, the second component 33 can be configured so as to contact with the ends 35_1 and 35_2 (i.e., the longitudinal ends) of the protruding parts 34_1 and 34_2. That is, when configuring the housing 30, the cut-out part may be formed in the area corresponding to the area where the antenna 39 is arranged, and the first component 32 is formed in the cut-out part, and the second component 33 is formed so as to contact with the ends 35_1 and 35_2 of the protruding parts 34_1 and 34_2. Thus, configuring the second component 33 to contact with the ends 35_1 and 35_2 of the protruding parts 34_1 and 34_2 of the housing main body 31, the impact exerted on the second component 33 can be received by the ends 35_1 and 35_2 of the protruding parts 34_1 and 34_2. Therefore, the impact exerted on the first component 32 and the antenna 39 can be reduced.

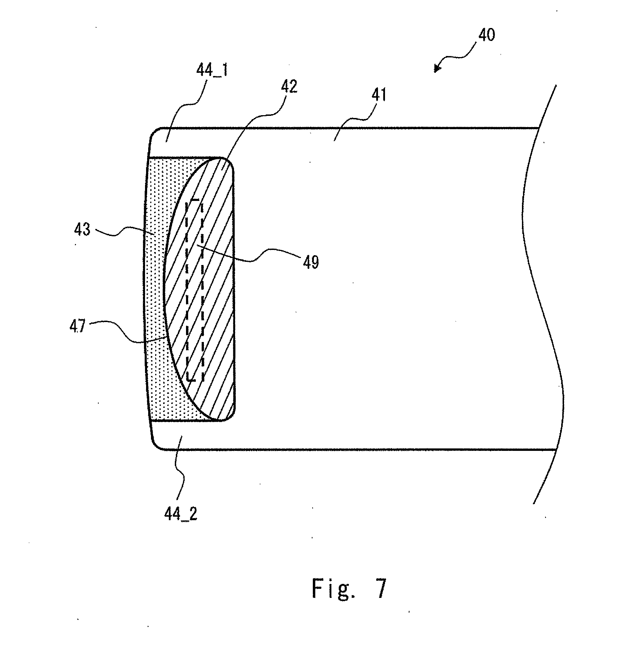

As shown in Fig. 7, in the portable terminal device according to this exemplary embodiment, the second component 43 can be configured so as to have a curvature structure 47 at a side where the second component 43 contacts the first component 42. That is, when configuring the housing 30 by forming the cut-out part in the area corresponding to the area where the antenna 49 is arranged, by forming the first component 42 in the cut-out part, and by forming the second component 43 from the protruding part 44_1 to the protruding part 44_2, the area where the first component 42 contacts the second component 43 can be configured with the curvature structure 47. Thus, by forming the curvature structure 47, the impact resistance of the second component 43 can be further improved.

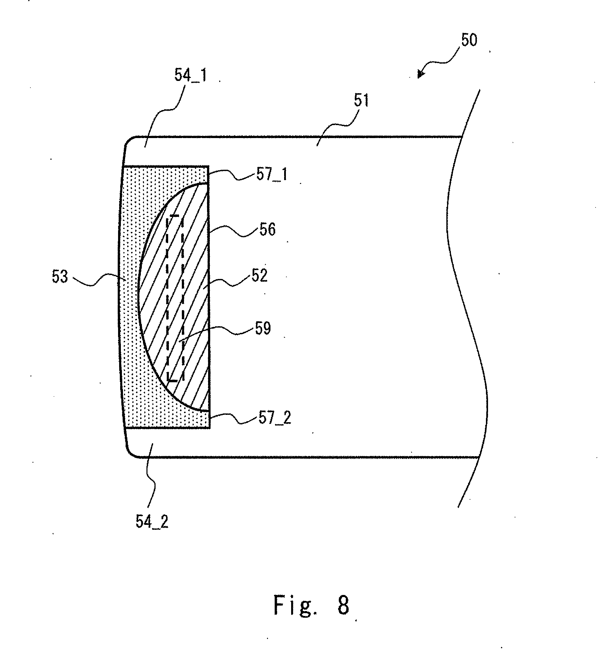

As shown in Fig. 8, in the portable terminal device according to this exemplary embodiment, the second component 53 can be configured so as to contact the housing main body 51 at the end 56 of the cut-out part that is sandwiched between the protruding part 54_1 and the protruding part 54_2. That is, when configuring the housing 50 by forming the cut-out part in the area corresponding to the area where the antenna 59 is arranged, by forming the first component 52 in the cut-out part, and by forming the second component 53 from the protruding part 54_1 to the protruding part 54_2, the second component 53 can be configured so as to contact the housing main body 51 at an end 56 (the ends 57_1 and 57_2 in Fig. 8) of the cut-out part.

Thus, by configuring the second component 53 to contact the housing main body 51 at the ends 57_1 and 57_2 of the cut-out part, the impact exerted on the second component 53 can be received by the ends 57_1 and 57_2 of the housing main body 51. Therefore, the impact exerted on the first component 52 and the antenna 59 can be reduced.

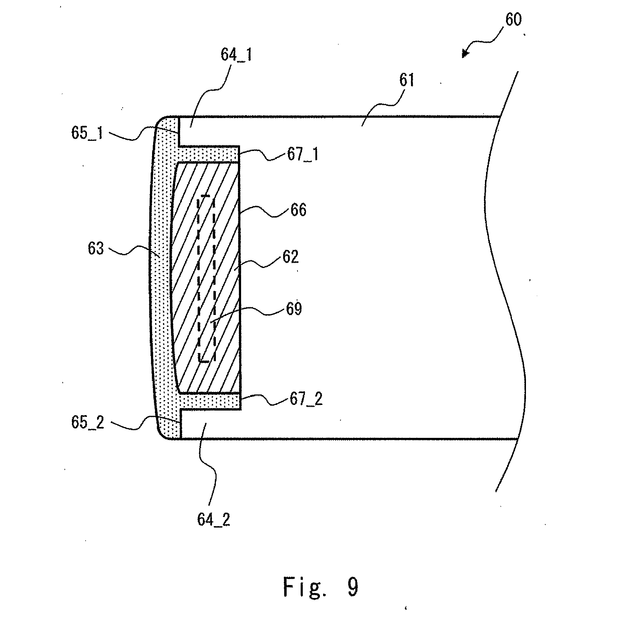

As shown in Fig. 9, in the portable terminal device according to this exemplary embodiment, the second component 63 can be configured so as to contact the housing main body 61 at the ends 65_1 and 65_2 of the protruding parts 64_1 and 64_2 and at the end 66 (the ends 67_1 and 67_2 in Fig. 9) of the cut-out part. That is, when configuring the housing 60 by forming the cut-out part in the area of the housing main body 61 corresponding to the area where the antenna 69 is arranged, by forming the first component 62 in the cut-out part, and by forming the second component 63 from the protruding part 64_1 to the protruding part 64_2, the second component 63 can be configured so as to contact the housing main body 61 at the ends 65_1 and 65_2 of the protruding parts 64_1 and 64_2 and at the ends 67_1 and 67_2 of the cut-out part.

Thus, configuring the second component 63 to contact the housing main body 61 at the ends 65_1 and 65_2 of the protruding parts 64_1 and 64_2 and at the ends 67_1 and 67_2 of the cut-out part, the impact exerted on the second component 63 can be received by the ends 65_1, 65_2, 67_1, and 67_2 of the housing main body 61. Therefore, the impact exerted on the first component 62 and the antenna 69 can be reduced.

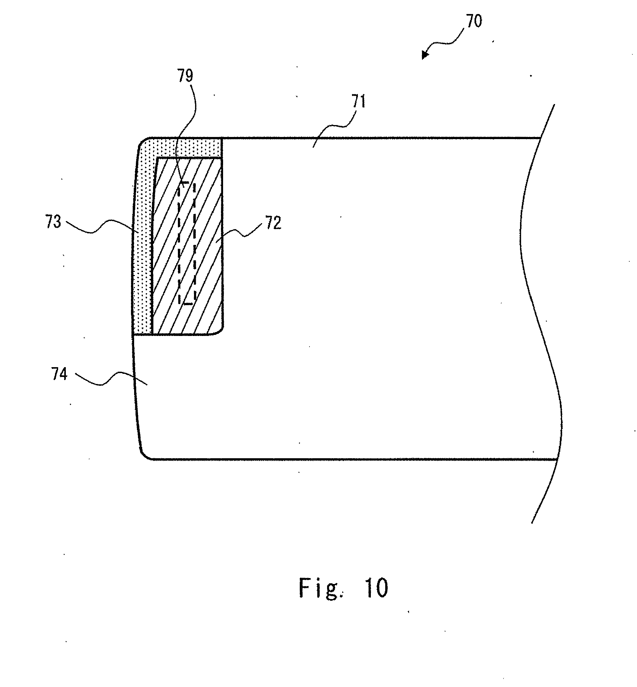

As shown in Fig. 10, in the portable terminal device according to this exemplary embodiment, the cut-out part is formed so as to include a corner of the housing 70. In this case, the main body of the housing 70 has only one protruding part 74. That is, the housing 70 can be configured by forming the cut-out part in the area (including the corner) of the housing main body 71 corresponding to the area where the antenna 79 is arranged, and forming the first component 72 in the cut-out part, and forming the second component 73 so as to surround the first component 72 at the end (including the corner) of the housing 70.

Note that, in Fig. 10, the case where the cut-out part is formed at only one corner of the end of the housing 70 has been shown. However, in the portable terminal device according to this exemplary embodiment, cut-out parts can be formed at two corners of the end of the housing. In this case, the housing is configured by forming first components at each of the cut-out parts, and forming the second components so as to surround each of the first components.

Although the present invention is explained above with reference to exemplary embodiments, the present invention is not limited to the above-described exemplary embodiments. Various modifications that can be understood by those skilled in the art can be made to the configuration and details of the present invention within the scope of the invention.

This application is based upon and claims the benefit of priority from Japanese patent application No. 2012-54245, filed on March 12, 2012, the disclosure of which is incorporated herein in its entirety by reference.

### Reference Signs List

- 1: PORTABLE TERMINAL DEVICE
- 2: PANEL (TOUCH PANEL)
- 3: DISPLAY PANEL
- 4: DISPLAY SECTION
- 5: FRAME COMPONENT
- 6: BATTERY
- 7: SUBSTRATE
- 8: CIRCUIT COMPONENT
- 9_1, 9_2: ANTENNAS
- 10: HOUSING
- 11: HOUSING MAIN BODY
- 12, 15: FIRST COMPONENTS
- 13, 16: SECOND COMPONENTS
- 17_1, 17_2, 18_1, 18_2: PROTRUDING PARTS

## Claims

1. A portable terminal device comprising:
a display section; and
a housing to which the display section is fixed,
wherein the housing comprises:
a housing main body that contains a conductive material and is formed with a cut-out part in a place corresponding to a place where an antenna is disposed at an end of the housing;
a first component that is arranged at the cut-out part and contains material that transmits radio waves; and
a second component that is formed so as to surround the first component at the end of the housing and has a higher rigidity than that of the first component.

2. The portable terminal device according to Claim 1, wherein
the housing main body comprises first and second protruding parts that are formed at both sides of the cut-out part, and
the second component is formed from the first protruding part to the second protruding part.

3. The portable terminal device according to Claim 1 or 2, wherein
the housing has a curvature structure at a longitudinal end of the housing, and
the second component includes the most protruding part in the curvature structure in a longitudinal direction of the housing.

4. The portable terminal device according to any one of Claims 1 to 3,
wherein the second component is formed so as to contact longitudinal ends of the first and second protruding parts.

5. The portable terminal device according to any one of Claims 1 to 4,
wherein the second component has a curvature structure at a side where the second component contacts the first component.

6. The portable terminal device according to any one of Claims 1 to 5,
wherein the second component is formed so as to contact the housing main body at an end of the cut-out part that is sandwiched between the first protruding part and the second protruding part.

7. The portable terminal device according to Claim 1, wherein the cut-out part is formed so as to include a corner of the housing.

8. The portable terminal device according to any one of Claims 1 to 7,
wherein
the housing main body contains carbon composite material,
the first component is formed by using resin material, and
the second component is formed by using resin material that has higher rigidity than that of the first component.

9. The portable terminal device according to any one of Claims 1 to 7,
wherein
the housing main body contains carbon composite material,
the first component is formed by using resin material, and
the second component is formed by using resin material that is thicker than that of the first component.

10. The portable terminal device according to Claim 8 or 9, wherein
the carbon composite material that comprises the housing main body includes a plurality of stacked carbon fiber layers, and
a direction of carbon fibers of at least carbon fiber layers disposed on an outer surface and inner surface of the housing among the plurality of carbon fiber layers coincides with a longitudinal direction of the housing.
